# EUROPEAN PATENT APPLICATION

(11) **EP 4 836 628 A1**
(43) Date of publication of application: **04.11.2026**
(21) Application number: 25741411.0
(22) Date of filing: 09.01.2025
(51) Int. Cl.: H10D 30/62

(54) **SEMICONDUCTOR STRUCTURE MANUFACTURING METHOD, SEMICONDUCTOR STRUCTURE, ELECTRONIC DEVICE, AND ELECTRONIC APPARATUS**

(30) Priority: 16.01.2024 CN 202410068254
(71) Applicant: Huawei Technologies Co., Ltd., Shenzhen, Guangdong 518129 (CN)
(72) Inventor: QIN, Qing, Shenzhen, Guangdong 518129 (CN); XU, Huan, Shenzhen, Guangdong 518129 (CN); ZHANG, Yanbin, Shenzhen, Guangdong 518129 (CN)
(74) Representative: Thun, Clemens
(86) International application number: PCT/CN2025/071549
(87) International publication number: WO 2025/152849

(57) **Abstract**

A semiconductor structure manufacturing method, a semiconductor structure, an electronic component, and an electronic device are provided, to resolve a technical problem of a large resistance between a channel layer and a source structure and between the channel layer and a drain structure. According to the semiconductor structure manufacturing method, when a void is formed, a portion of the channel layer that is in contact with a sacrificial layer is removed, reducing a thickness of the channel layer corresponding to the void. In addition, when a second groove is formed, a portion of the channel layer corresponding to the void is removed, that is, a portion of the channel layer with a small thickness is removed. In this way, a contact area between the channel layer and an electrode structure is increased, and the resistance between the channel layer and the electrode structure is reduced.

## Description

This application claims priority to Chinese Patent Application No. 202410068254.0, filed with the China National Intellectual Property Administration on January 16, 2024 and entitled "SEMICONDUCTOR STRUCTURE MANUFACTURING METHOD, SEMICONDUCTOR STRUCTURE, ELECTRONIC COMPONENT, AND ELECTRONIC DEVICE", which is incorporated herein by reference in its entirety.

### TECHNICAL FIELD

Embodiments of this application relate to the field of semiconductor fabrication technologies, and specifically, to a semiconductor structure manufacturing method, a semiconductor structure, an electronic component, and an electronic device.

### BACKGROUND

Gate all around (gate all around, GAA for short) transistors have been widely used due to their high control capability. A gate all around transistor includes a plurality of gate layers and a plurality of channel layers that are alternately stacked. One end of each channel layer is connected to a source structure, and the other end of the channel layer is connected to a drain structure. A portion of the channel layer that is in contact with the source structure and the drain structure has a small thickness, resulting in a large resistance between the channel layer and the source structure and between the channel layer and the drain structure.

### SUMMARY

Embodiments of this application provide a semiconductor structure manufacturing method, a semiconductor structure, an electronic component, and an electronic device, to reduce a resistance between a channel layer and a source structure and between the channel layer and a drain structure.

According to a first aspect, an embodiment of this application provides a semiconductor structure manufacturing method, including: forming a stacked structure on a substrate, where the stacked structure includes a plurality of sacrificial layers and a plurality of channel layers that are alternately stacked; forming a plurality of dummy gate structures on the stacked structure, where the plurality of the dummy gate structures are spaced apart; forming a first mask layer on each of the dummy gate structures, where the first mask layer covers a side wall that is of the dummy gate structure and that is adjacent to the stacked structure; forming a second mask layer on the first mask layer; removing a portion of the stacked structure by using the second mask layer as a mask, to form a plurality of first grooves, where the first groove extends to the substrate; removing a portion of the sacrificial layer on a wall of the first groove to form a void; removing the second mask layer; forming, by using the first mask layer as a mask, a second groove extending to the substrate; and forming, at the second groove, an electrode structure in contact with each of the channel layers.

According to the semiconductor structure manufacturing method provided in this embodiment of this application, when the void is formed, a portion of the channel layer that is in contact with the sacrificial layer is removed, reducing a thickness of the channel layer corresponding to the void. In addition, when the second groove is formed, a portion of the channel layer corresponding to the void is removed, that is, a portion of the channel layer with a small thickness is removed. In this way, a contact area between the channel layer and the electrode structure is increased, and the resistance between the channel layer and the electrode structure is reduced.

In some embodiments that may include the foregoing embodiment, before forming the second mask layer on the first mask layer, the method further includes: forming a stop layer on the first mask layer, where etch selectivity of the stop layer is not equal to either etch selectivity of the first mask layer or etch selectivity of the second mask layer; and before forming, by using the first mask layer as the mask, the second groove extending to the substrate, the method further includes: removing the stop layer. In this way, when the second mask layer is removed, the stop layer can protect the first mask layer from damage.

In some embodiments that may include the foregoing embodiment, removing the portion of the sacrificial layer on the wall of the first groove to form the void includes: removing a portion of the channel layer that is in contact with the sacrificial layer while removing the portion of the sacrificial layer on the wall of the first groove, to form a thinned region on the channel layer. In this way, the sacrificial layer in the void may be fully removed, to avoid a residual portion of the sacrificial layer in the void.

In some embodiments that may include the foregoing embodiment, the forming, by using the first mask layer as the mask, the second groove extending to the substrate includes: removing at least a portion of the thinned region on each of the channel layers while forming the second groove. In this way, a thickness of the channel layer at a leakage point is large, that is, the contact area between the channel layer and the electrode structure is increased, reducing the resistance between the channel layer and the electrode structure.

In some embodiments that may include the foregoing embodiment, before removing the second mask layer, the method further includes: forming a filler in the void. In this way, the filler can support the channel layer at the void, to prevent the channel layer from falling off in a subsequent manufacturing process. In addition, the filler may further isolate the sacrificial layer, to isolate a gate layer from the electrode structure.

In some embodiments that may include the foregoing embodiment, the forming the filler in the void includes: forming a first dielectric layer on the wall of the first groove, where a portion of the first dielectric layer is filled in the void to form the filler; and removing the first dielectric layer on the wall of the first groove. In this way, simple manufacturing is achieved and it can be ensured that the filler fully fills the void.

In some embodiments that may include the foregoing embodiments, forming, at the second groove, the electrode structure in contact with each of the channel layers includes: forming the electrode structure by epitaxial growth based on the channel layer on a wall of each second groove. In this way, the electrode structure formed by epitaxial growth and the channel layer form an integrated structure, reducing the resistance between the channel layer and the electrode structure.

In some embodiments that may include the foregoing embodiments, after forming, at the second groove, the electrode structure in contact with each of the channel layers, the method further includes: replacing the sacrificial layers with gate layers, where the gate layers are connected to each other. In this way, each of the gate layers corresponding to each stacked sub-structure is used as a gate of a gate all around transistor, each of the channel layers corresponding to the stacked sub-structure is used as a channel of the gate all around transistor, an electrode structure at one end of the stacked sub-structure is used as a source of the gate all around transistor, and the electrode structure at the other end of the stacked sub-structure is used as a drain of the gate all around transistor.

According to a second aspect, an embodiment of this application further provides a semiconductor structure, and the semiconductor structure is obtained by using the foregoing semiconductor structure manufacturing method. The semiconductor structure provided in this embodiment of this application is obtained by using the semiconductor structure manufacturing method in the foregoing embodiment. Therefore, the semiconductor structure and the semiconductor structure manufacturing method can resolve a same technical problem and achieve same technical effects.

According to a third aspect, an embodiment of this application further provides an electronic component, including a package substrate and the semiconductor structure described above, where the semiconductor structure is disposed on the package substrate.

The electronic component provided in this embodiment of this application includes the semiconductor structure in any one of the foregoing embodiments. Therefore, the electronic component and the semiconductor structure can resolve a same technical problem and achieve same technical effects.

According to a fourth aspect, an embodiment of this application further provides an electronic device, including a circuit board and the foregoing electronic component, where the electronic component is disposed on the circuit board.

The electronic device provided in this embodiment of this application includes the semiconductor device in any one of the foregoing embodiments. Therefore, the electronic device and the semiconductor device can resolve a same technical problem and achieve same technical effects.

### BRIEF DESCRIPTION OF DRAWINGS

FIG. 1 is a diagram of a structure of a planar transistor in a conventional technology;
FIG. 2 is a diagram of a structure of a fin field-effect transistor in a conventional technology;
FIG. 3 is a diagram of a structure of a gate all around transistor in a conventional technology;
FIG. 4 is a sectional view of a gate all around transistor in a conventional technology;
FIG. 5 is a flowchart of a semiconductor structure manufacturing method according to an embodiment of this application;
FIG. 6 is a three-dimensional diagram obtained after a second mask layer is formed in a conductor structure manufacturing method according to an embodiment of this application;
FIG. 7 is a sectional view obtained after a second mask layer is formed in a conductor structure manufacturing method according to an embodiment of this application;
FIG. 8 is a three-dimensional diagram obtained after a first groove is formed in a conductor structure manufacturing method according to an embodiment of this application;
FIG. 9 is a sectional view 1 obtained after a first groove is formed in a conductor structure manufacturing method according to an embodiment of this application;
FIG. 10 is a three-dimensional diagram obtained after a void is formed in a conductor structure manufacturing method according to an embodiment of this application;
FIG. 11 is a sectional view obtained after a void is formed in a conductor structure manufacturing method according to an embodiment of this application;
FIG. 12 is a sectional view obtained after a first dielectric layer is formed in a conductor structure manufacturing method according to an embodiment of this application;
FIG. 13 is a sectional view obtained after a first dielectric layer on a wall of a first groove is removed in a conductor structure manufacturing method according to an embodiment of this application;
FIG. 14 is a sectional view obtained after a second mask layer is removed in a conductor structure manufacturing method according to an embodiment of this application;
FIG. 15 is a sectional view obtained after a second groove is formed in a conductor structure manufacturing method according to an embodiment of this application;
FIG. 16 is a sectional view obtained after an electrode structure is formed in a conductor structure manufacturing method according to an embodiment of this application; and
FIG. 17 is a sectional view 2 obtained after a first groove is formed in a conductor structure manufacturing method according to an embodiment of this application.

Reference numerals: 10: substrate; 101: shallow trench isolation structure; 20: stacked structure; 201: channel layer; 202: sacrificial layer; 203: gate layer; 204: channel structure; 205: filler; 206: first dielectric layer; 207: void; 208: thinned region; 210: stacked sub-structure; 30: dummy gate structure; 301: hard mask; 302: first hard mask; 303: second hard mask; 304: second dielectric layer; 305: isolation layer; 306: first mask layer; 307: second mask layer; 308: stop layer; 310: source structure; 320: drain structure; 401: first groove; 402: second groove.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

The terms "first" and "second" mentioned below are merely intended for a purpose of description, and shall not be understood as an indication or implication of relative importance or implicit indication of the quantity of indicated technical features. Therefore, a feature limited by "first", "second", or the like may explicitly or implicitly include one or more features.

In addition, in embodiments of this application, orientation terms such as "above", "below", "left", "right", "horizontal", and "vertical" are defined relative to placement orientations of components shown in the accompanying drawings. It should be understood that these directional terms are relative concepts that are used for relative description and clarification, and may vary correspondingly based on changes in the placement orientations of the components in the accompanying drawings.

In embodiments of this application, unless otherwise specified and limited, the term "connection" should be understood in a broad sense. For example, the "connection" may be a fixed connection, an electrical connection, a detachable connection, an integration, a direct connection, or an indirect connection by using an intermediate medium.

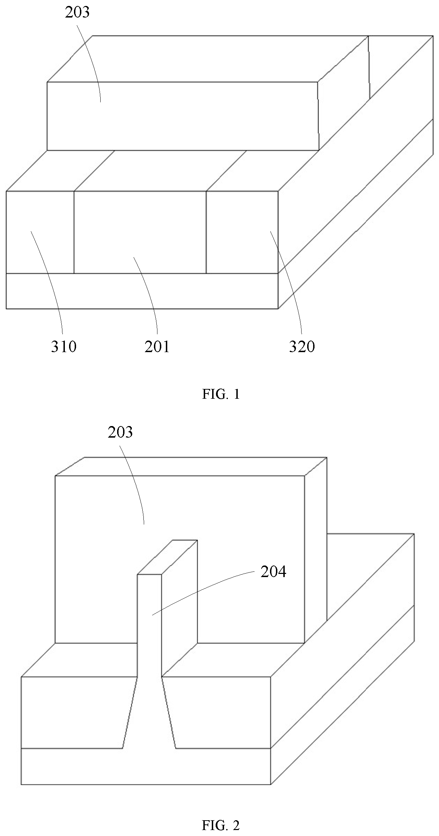

With gradual advancement of semiconductor technologies, transistors have evolved from planar transistors to fin field-effect transistors (FinFETs) and gate all around (GAA) transistors. As shown in FIG. 1, a planar transistor includes a channel layer 201 and a gate layer 203 stacked on the channel layer 201. The planar transistor may be controlled by using the gate layer 203. As shown in FIG. 2, a fin field-effect transistor includes a fin-shaped channel structure 204, and the gate layer 203 covers a top surface and two side surfaces of the channel structure 204, to increase a contact area between the gate layer 203 and the channel structure 204, improving a control capability of the fin field-effect transistor.

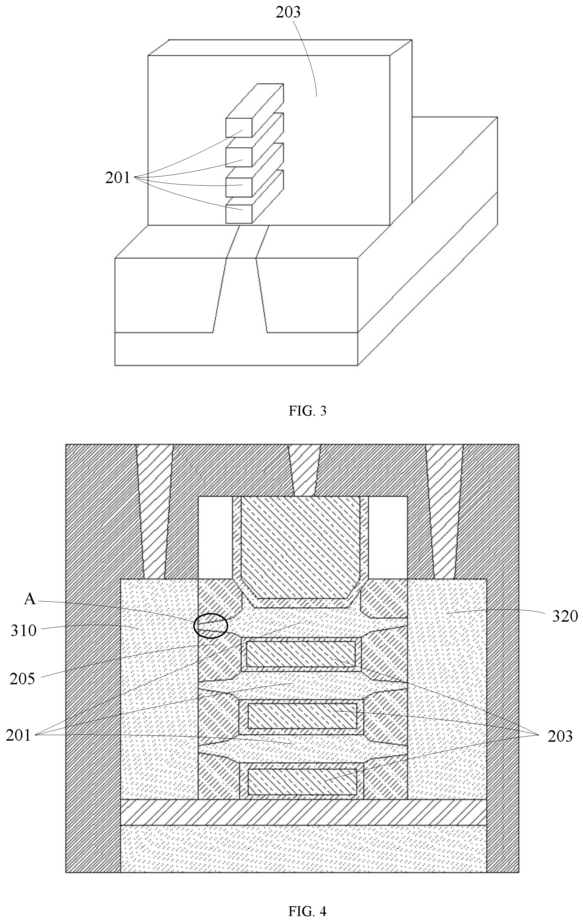

As shown in FIG. 3 and FIG. 4, a gate all around transistor includes a plurality of channel layers 201 that are stacked. One gate layer 203 is disposed between adjacent channel layers 201, and the plurality of gate layers 203 are connected. One end of the channel layer 201 is connected to a source structure 310, and the other end of the channel layer 201 is connected to a drain structure 320. Each of the channel layers 201 is located between the source structure 310 and the drain structure 320. During manufacturing, to prevent the source structure 310 and the drain structure 320 from contacting the gate layer 203, the plurality of channel layers 201 and the plurality of sacrificial layers usually need to be first alternately stacked and formed to form a stacked structure. Then, portions of the sacrificial layers at two ends of the stacked structure are removed by etching to form voids, and the voids are filled with fillers 205. Then, the source structure 310 is formed at one end of the stacked structure, and the drain structure 320 is formed at the other end of the stacked structure 20.

However, when the portions of the sacrificial layers at the two ends of the stacked structure are removed, portions of the channel layers 201 adjacent to the sacrificial layers are removed, so that thicknesses of portions of the channel layers 201 that are in contact with the source structure 310 and the drain structure 320 are small (at A in FIG. 4), resulting in a large resistance between the channel layer 201 and the source structure 310 and between the channel layer 201 and the drain structure 320.

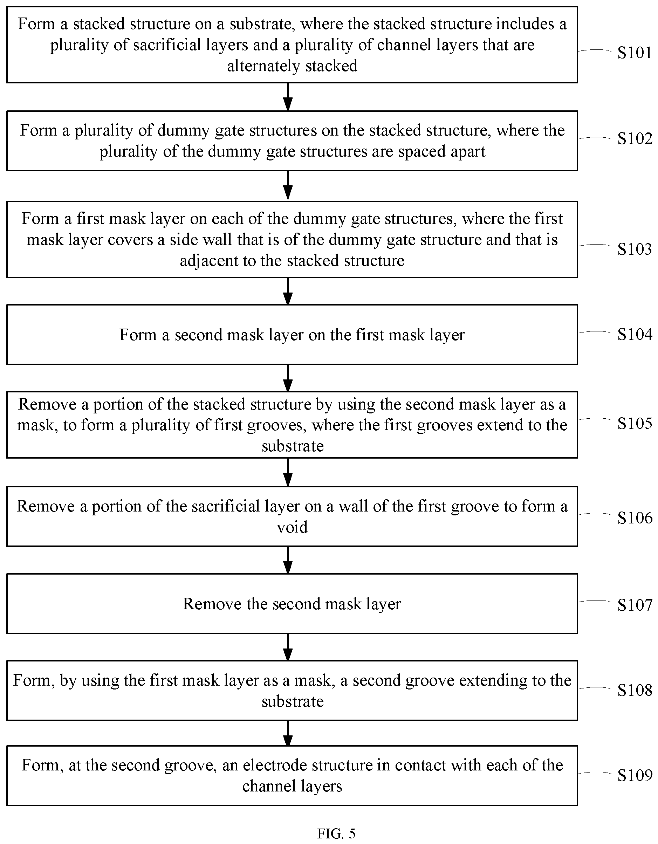

Refer to FIG. 5. An embodiment of this application provides a semiconductor structure manufacturing method, used to manufacture a semiconductor structure. The semiconductor structure may include a gate all around transistor. The method includes the following steps.

S101: Form a stacked structure on a substrate, where the stacked structure includes a plurality of sacrificial layers and a plurality of channel layers that are alternately stacked.

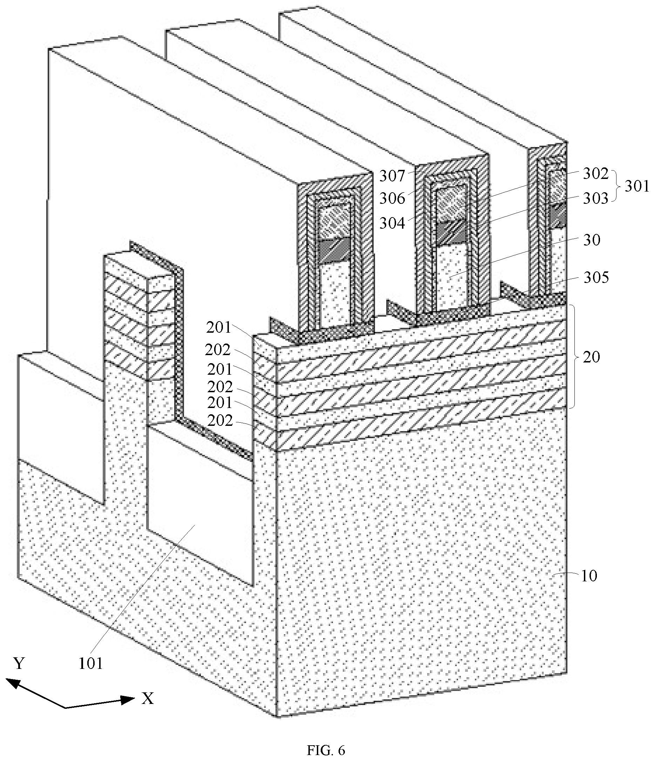

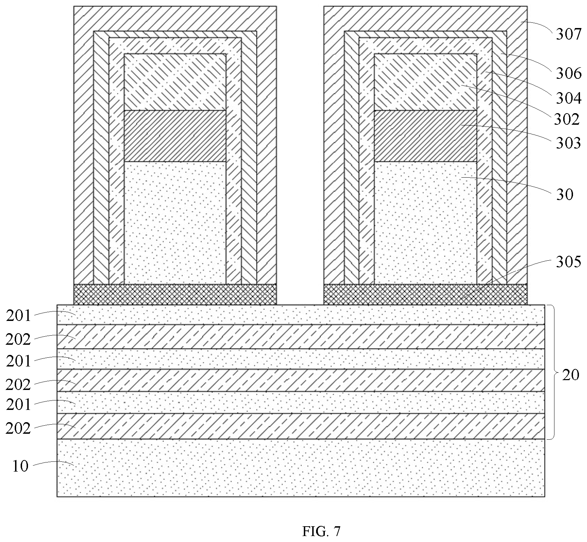

Refer to FIG. 6 and FIG. 7. The plurality of sacrificial layers 202 and the plurality of channel layers 201 are alternately stacked. For example, a sacrificial layer 202 may be first formed on the substrate 10, next a channel layer 201 is formed on the sacrificial layer 202, and then another sacrificial layer 202 is formed on the channel layer 201, and so on. It is clear that alternatively, a channel layer 201 may be first formed on the substrate 10, next a sacrificial layer 202 is formed on the channel layer 201, and then another channel layer 201 is formed on the sacrificial layer 202, and so on.

In this embodiment of this application, a material of the substrate 10 may include silicon (Si), germanium (Ge), or the like. A material of the channel layer 201 may include silicon, germanium, or the like, and the channel layer 201 may be used as a channel of the gate all around transistor. A material of the sacrificial layer 202 may include silicon germanium (SiGe), silicon oxide (SiOx), silicon nitride (SiN), or the like. The material of the sacrificial layer 202 is not limited in embodiments of this application, provided that etch selectivity of the sacrificial layer 202 is not equal to that of the channel layer 201.

In some embodiments, the stacked structure 20 may extend on the substrate 10 in a first direction (an X direction in FIG. 6). There may be a plurality of stacked structures 20, and the plurality of stacked structures 20 may be spaced apart on the substrate 10 in a second direction (a Y direction in FIG. 6) that is perpendicular to the first direction. Adjacent stacked structures 20 may be isolated by using a shallow trench isolation structure 101. For example, the shallow trench isolation structure 101 may be formed in the substrate 10 between the adjacent stacked structures 20. A material of the shallow trench isolation structure 101 may include silicon oxide, silicon oxynitride (SiON), or the like.

Still refer to FIG. 5. After the stacked structure 20 is formed, the semiconductor structure manufacturing method provided in this embodiment of this application further includes the following step.

S102: Form a plurality of dummy gate structures on the stacked structure, where the plurality of the dummy gate structures are spaced apart.

Still refer to FIG. 6 and FIG. 7. For example, the plurality of dummy gate structures 30 may be spaced apart in the first direction. A material of the dummy gate structure 30 may include monocrystalline silicon, polycrystalline silicon, or the like.

It may be understood that, during manufacturing, an isolation layer 305 may be first formed on a surface that is of the stacked structure 20 and that is away from the substrate 10 and on a side surface adjacent to the surface. Then, a dummy gate layer is formed on the isolation layer 305, and a hard mask 301 is formed on the dummy gate layer. A portion of the dummy gate layer and the isolation layer 305 are removed by using the hard mask 301 as a mask, to form the plurality of dummy gate structures 30 that are spaced apart, and each dummy gate structure 30 is isolated from the stacked structure 20 by using the isolation layer 305. A material of the isolation layer 305 may include silicon oxide, silicon oxynitride, or the like.

In the foregoing implementation, the hard mask 301 may include a first hard mask 302 and a second hard mask 303 that are stacked. The second hard mask 303 is located between the dummy gate layer and the first hard mask 302. A material of the first hard mask 302 may include silicon oxide, silicon oxynitride, or the like, and a material of the second hard mask 303 may include silicon nitride, or the like.

Still refer to FIG. 5. After the dummy gate structures 30 are formed, the semiconductor structure manufacturing method provided in this embodiment of this application further includes the following step.

S103: Form a first mask layer on each of the dummy gate structures, where the first mask layer covers a side wall that is of the dummy gate structure and that is adjacent to the stacked structure.

Still refer to FIG. 6 and FIG. 7. For example, a material of the first mask layer 306 may include silicon nitride, silicon oxynitride, or the like.

It may be understood that, while covering the side wall that is of the dummy gate structure 30 and that is adjacent to the stacked structure 20, the first mask layer 306 further covers a surface that is of the dummy gate structure 30 and that is away from the substrate 10.

Still refer to FIG. 5. After the first mask layer 306 is formed, the semiconductor structure manufacturing method provided in this embodiment of this application further includes the following step.

S104: Form a second mask layer on the first mask layer.

Still refer to FIG. 6 and FIG. 7. For example, the second mask layer 307 may completely cover the first mask layer 306. A material of the second mask layer 307 may include silicon oxide, silicon oxynitride, or the like.

Still refer to FIG. 5. After the second mask layer 307 is formed, the semiconductor structure manufacturing method provided in this embodiment of this application further includes the following step.

S105: Remove a portion of the stacked structure by using the second mask layer as a mask, to form a plurality of first grooves, where the first grooves extend to the substrate.

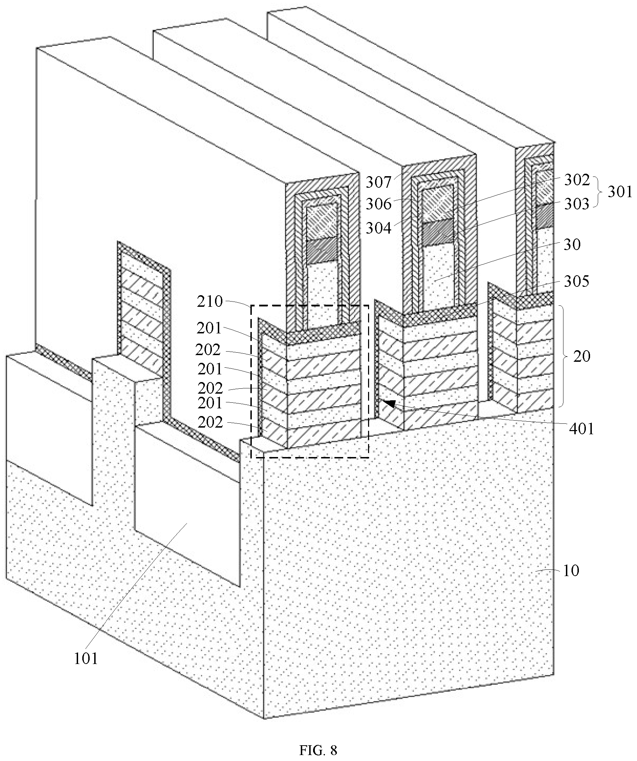

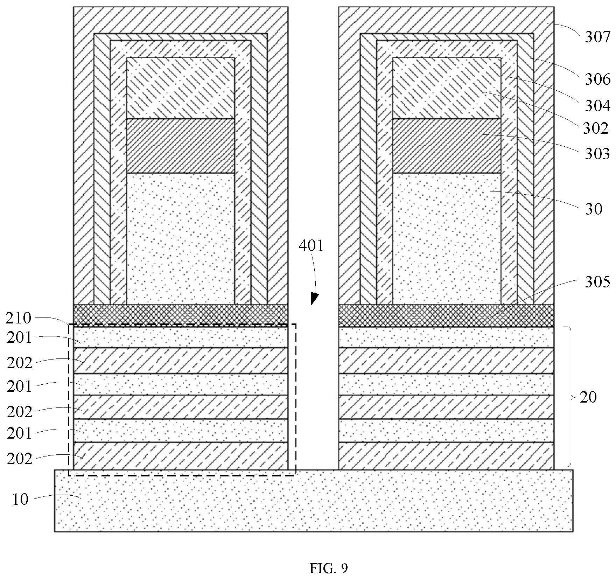

Refer to FIG. 8 and FIG. 9. For example, the portion of the stacked structure 20 may be removed by dry etching, wet etching, or the like, to form a first groove 401 extending to the substrate 10. The first groove 401 divides the stacked structure 20 into a plurality of stacked sub-structures 210.

Still refer to FIG. 5. After the first groove 401 is formed, the semiconductor structure manufacturing method provided in this embodiment of this application further includes the following step.

S106: Remove a portion of the sacrificial layer on a wall of the first groove to form a void.

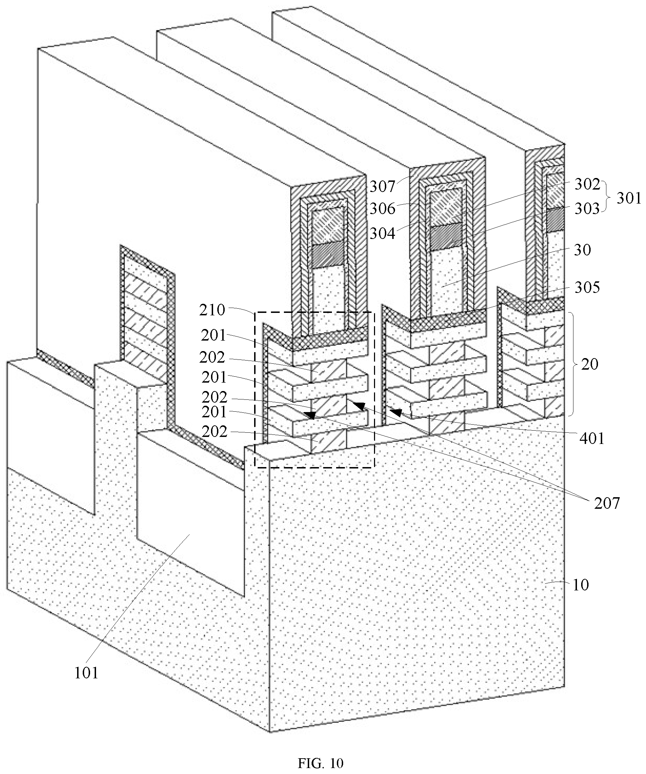

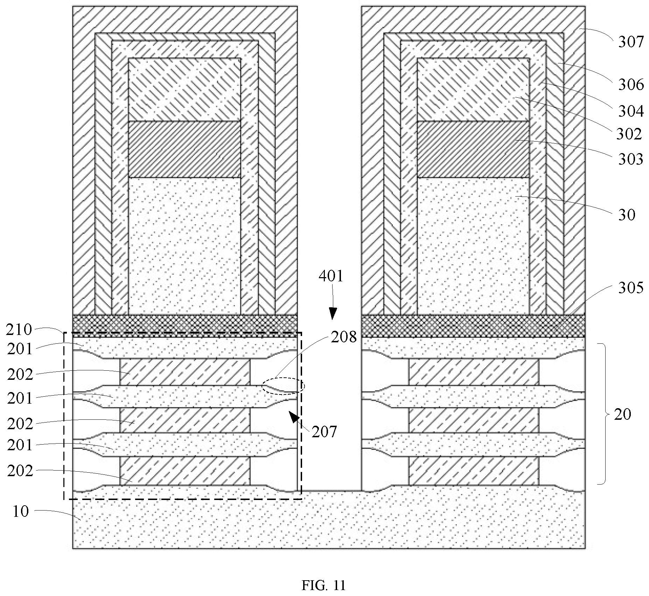

Refer to FIG. 10 and FIG. 11. It may be understood that, the etch selectivity of the sacrificial layer 202 is not equal to that of the channel layer 201, so that the portion of the sacrificial layer 202 on the wall of the first groove 401 may be removed by selective etching. In other words, a portion of the sacrificial layer 202 that is in the stacked sub-structure 210 and that is close to the first groove 401 is removed, to form the void 207.

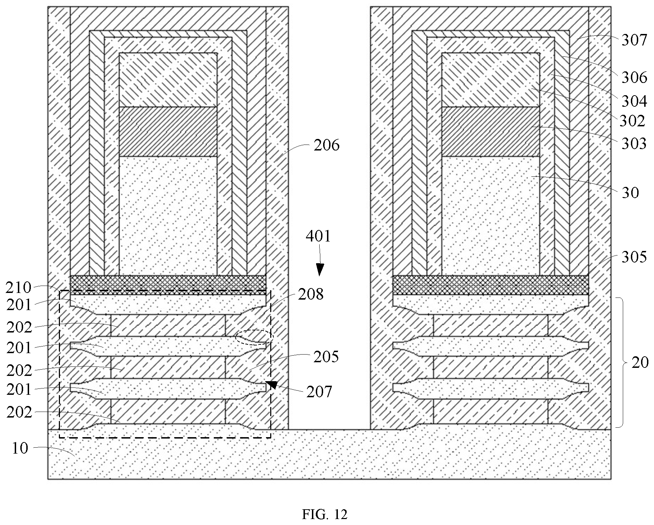

As shown in FIG. 12, after the void 207 is formed, a filler 205 may be filled in the void 207. The filler 205 may support the channel layer 201 at the void 207, to prevent the channel layer 201 from falling off in a subsequent manufacturing process. In addition, the filler 205 may further isolate the sacrificial layer 202. For example, a material of the filler 205 may include an insulation material such as silicon oxycarbide (SiCO) or silicon oxycarbonitride (SiOCN).

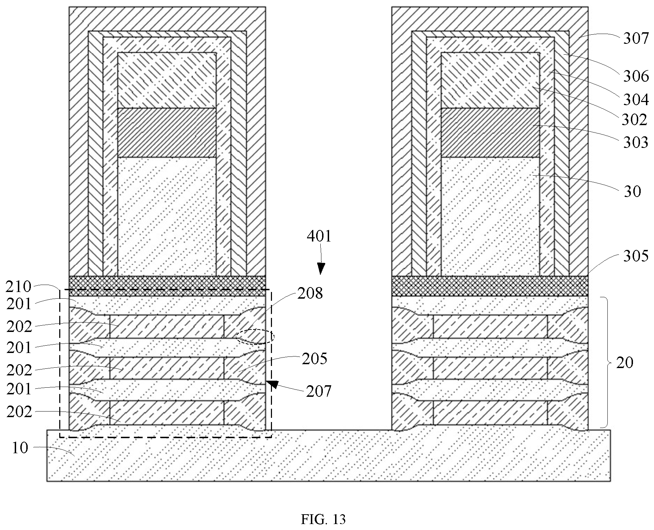

For example, forming the filler 205 in the void 207 includes: forming a first dielectric layer 206 on the wall of the first groove 401, where a portion of the first dielectric layer 206 is filled in the void 207 to form the filler 205. As shown in FIG. 13, after that, the first dielectric layer 206 on the wall of the first groove 401 is removed, to retain the filler 205 located in the void 207. In this way, simple manufacturing is achieved and it can be ensured that the filler 205 fully fills the void 207.

Still refer to FIG. 5. After the void 207 is formed, the semiconductor structure manufacturing method provided in this embodiment of this application further includes the following step.

S107: Remove the second mask layer.

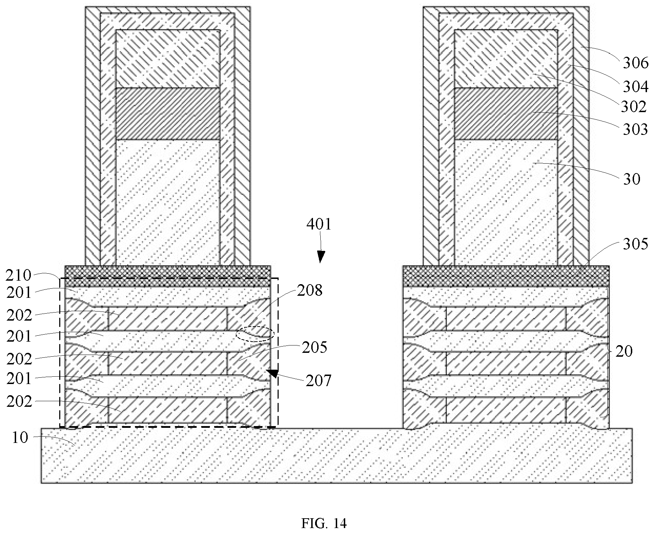

As shown in FIG. 14, for example, the second mask layer 307 may be removed by dry etching or wet etching. This is not limited in embodiments of this application.

In some embodiments, etch selectivity of the first mask layer 306 may be not equal to that of the second mask layer 307. Correspondingly, when the second mask layer 307 is removed, the first mask layer 306 is retained.

Still refer to FIG. 5. After the second mask layer 307 is removed, the semiconductor structure manufacturing method provided in this embodiment of this application further includes the following step.

S108: Form, by using the first mask layer as a mask, a second groove extending to the substrate.

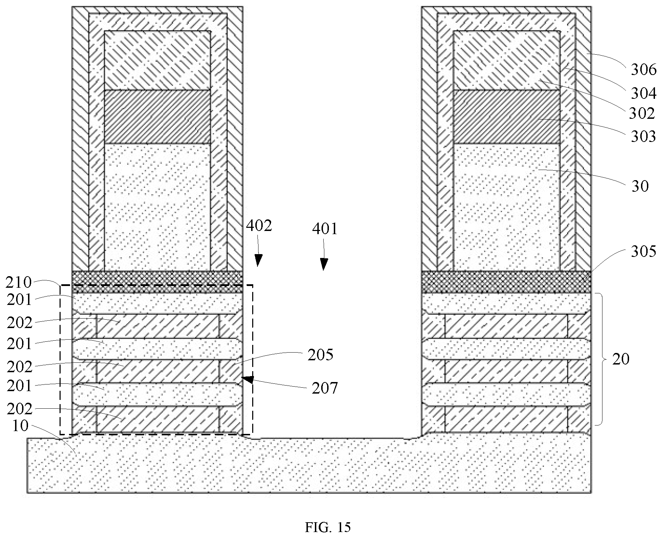

As shown in FIG. 15, for example, a portion of the stacked sub-structure 210 covered by the second mask layer 307 shown in FIG. 12 may be removed by wet etching or dry etching, to form the second groove 402 extending to the substrate 10, and the second groove 402 communicates with the first groove 401.

Still refer to FIG. 5. After the second groove 402 is formed, the semiconductor structure manufacturing method provided in this embodiment of this application further includes the following step.

S109: Form, at the second groove, an electrode structure in contact with each of the channel layers.

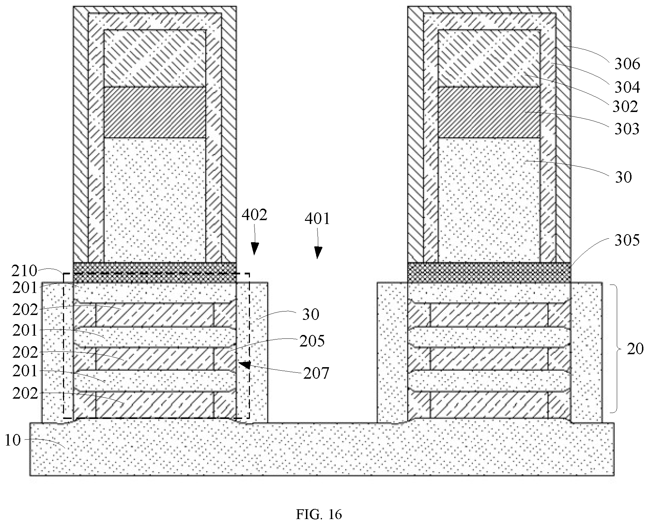

As shown in FIG. 16, the electrode structure 30 may be filled in the second groove 402 and the first groove 401, and the electrode structure 30 may be used as a source or a drain of the gate all around transistor. An orientation shown in FIG. 16 is used as an example. The electrode structure 30 on a left side of the stacked sub-structure 210 may be the source of the gate all around transistor, and the electrode structure 30 on a right side of the stacked sub-structure 210 is the drain of the gate all around transistor.

For example, based on the channel layer 201 on a wall of each second groove 402, the electrode structure 30 is formed by epitaxial growth. The electrode structure 30 formed by epitaxial growth and the channel layer 201 form an integrated structure, reducing the resistance between the channel layer 201 and the electrode structure.

In this embodiment of this application, after the electrode structure is formed, the sacrificial layers 202 may be replaced with gate layers, where the gate layers are connected to each other. In this way, each of the gate layers corresponding to each stacked sub-structure 210 is used as a gate of the gate all around transistor, each of the channel layers 201 corresponding to the stacked sub-structure 210 is used as a channel of the gate all around transistor, an electrode structure 30 at one end of the stacked sub-structure 210 is used as the source of the gate all around transistor, and an electrode structure 30 at the other end of the stacked sub-structure 210 is used as the drain of the gate all around transistor.

In the foregoing implementation, the gate layer may include a gate metal layer and a gate dielectric layer wrapped outside the gate metal layer. For example, a material of the gate metal layer may include tungsten, copper, or the like, and a material of the gate dielectric layer may include a high dielectric constant material (High-K) such as hafnium oxide.

According to the semiconductor structure manufacturing method provided in this embodiment of this application, as shown in FIG. 6 and FIG. 7, the stacked structure 20 includes the plurality of sacrificial layers 202 and the plurality of channel layers 201 that are alternately stacked. The plurality of dummy gate structures 30 are spaced apart on the stacked structure 20. Then, the first mask layer 306 is formed on the dummy gate structure 30, and the first mask layer 306 covers the side wall that is of the dummy gate structure 30 and that is adjacent to the stacked structure 20. The second mask layer 307 is formed on the first mask layer 306. Then, the portion of the stacked structure 20 is removed by using the second mask layer 307 as a mask, to form a plurality of first grooves 401 extending to the substrate 10 (as shown in FIG. 8 and FIG. 9). After that, the portion of the sacrificial layer 202 on the wall of the first groove 401 is removed to form the void 207 (as shown in FIG. 10 and FIG. 11). After the second mask layer 307 is removed, the second groove 402 (as shown in FIG. 15) extending to the substrate 10 is formed by using the first mask layer 306 as a mask, and the electrode structure in contact with each of the channel layers 201 is formed at the second groove 402. According to the foregoing configuration, when the void 207 is formed, a portion of the channel layer 201 that is in contact with the sacrificial layer 202 is removed (as shown in FIG. 11), reducing a thickness of the channel layer 201 corresponding to the void 207. In addition, when the second groove 402 is formed, a portion of the channel layer 201 corresponding to the void 207 is removed (as shown in FIG. 15), that is, a portion of the channel layer 201 with a small thickness is removed. In this way, a contact area between the channel layer 201 and the electrode structure 30 is increased, and the resistance between the channel layer 201 and the electrode structure 30 is reduced.

Still refer to FIG. 11. It may be understood that, the etch selectivity of the sacrificial layer 202 is not equal to that of the channel layer 201. However, when the portion of the sacrificial layer 202 on the wall of the first groove 401 is removed, a portion of the channel layer 201 that is in contact with the sacrificial layer 202 is also removed, forming a thinned region 208 on the channel layer 201. In this way, the thickness of the channel layer 201 is reduced. In this way, the sacrificial layer 202 in the void 207 may be fully removed, to avoid a residual portion of the sacrificial layer 202 in the void 207.

For a large enough filler 205 between the gate layer 203 and the electrode structure, a large void 207 usually needs to be formed. Correspondingly, the formed thinned region 208 is thick in a direction perpendicular to the substrate 10, so that the thickness of the channel layer 201 is further reduced. In this embodiment of this application, as shown in FIG. 15, when the second groove 402 is formed, at least a portion of the thinned region 208 (as shown in FIG. 11) is removed. In this way, a thickness of the channel layer 201 at a leakage point is large, that is, the contact area between the channel layer 201 and the electrode structure is increased, reducing the resistance between the channel layer 201 and the electrode structure.

Still refer to FIG. 6 and FIG. 7. In an implementation in which etch selectivity of the first mask layer 306 is not equal to that of the second mask layer 307, a thickness of the first mask layer 306 may be 10 Å to 50 Å (for example, 10 Å, 20 Å, 40Å or 50 Å), and a thickness of the second mask layer 307 may be 10 Å to 40 Å (for example, 10 Å, 20 Å, 30Å or 40 Å). In this way, the thickness of the second mask layer 307 is large. When the second groove 402 is formed (as shown in FIG. 15), a width of the formed second groove 402 is large in the first direction, further increasing the contact area between the channel layer 201 and the electrode structure.

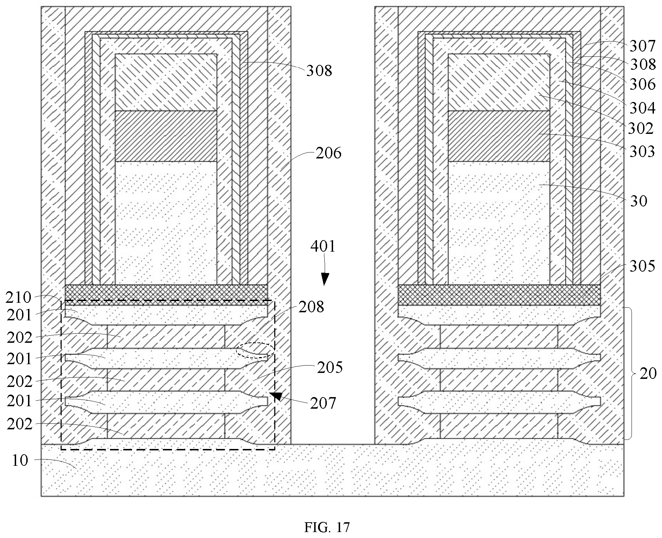

As shown in FIG. 17, in another embodiment, etch selectivity of the first mask layer 306 is equal or similar to that of the second mask layer 307. Correspondingly, before the second mask layer 307 is formed, a stop layer 308 needs to be formed on the first mask layer 306, and etch selectivity of the stop layer 308 is not equal to either etch selectivity of the first mask layer 306 or etch selectivity of the second mask layer 307. When the second mask layer 307 is removed, the stop layer 308 may protect the first mask layer 306 from damage. Before the second groove 402 shown in FIG. 15 is formed, the stop layer 308 needs to be removed, to ensure that the width of the second groove 402 is large in the first direction.

For example, a material of the stop layer 308 may include silicon oxide, silicon oxynitride, or the like. The material of the stop layer 308 is not limited in embodiments of this application, provided that it is ensured that the etch selectivity of the stop layer 308 is not equal to either etch selectivity of the first mask layer 306 or etch selectivity of the second mask layer 307.

As shown in FIG. 17, in an implementation in which the etch selectivity of the first mask layer 306 is equal or similar to that of the second mask layer 307, a sum of a thickness of the first mask layer 306 and a thickness of the stop layer 308 may be 35 Å to 45 Å (for example, 35 Å, 40 Å or 45 Å), and a thickness of the second mask layer 307 may be 10 Å to 30 Å (for example, 10 Å, 20 Å or 30 Å). In this way, on a premise that a sum of the thicknesses of the first mask layer 306, the stop layer 308, and the second mask layer 307 is not excessively large, the thickness of the second mask layer 307 is large, to ensure that the width of the formed second groove 402 is large in the first direction.

Still refer to FIG. 6 and FIG. 7. In this embodiment of this application, before the first mask layer 306 is formed, a second dielectric layer 304 may be formed on the dummy gate structure 30. The second dielectric layer 304 may cover the hard mask 301 and a side wall that is of the dummy gate structure 30 and that is adjacent to the stacked structure 20. A material of the second dielectric layer 304 may include a low dielectric constant material (Low-k) such as silicon oxycarbonitride (SiOCN). Capacitance effect between the gate all around transistors may be reduced by using the second dielectric layer 304.

An embodiment of this application further provides an electronic device. The electronic device may include a mobile phone, a computer, a tablet computer, a smart band, a smartwatch, AR, VR, and the like. The electronic device is not limited in embodiments of this application. The electronic device includes a circuit board and an electronic component disposed on the circuit board. The electronic component may include a central processing unit (CPU), a memory, and the like. The electronic component is electrically connected to a circuit on the circuit board.

In the foregoing implementation, the electronic component may include a package substrate and a semiconductor structure, and the semiconductor structure is packaged on the package substrate. For example, a package circuit may be disposed on the package substrate. The semiconductor structure is electrically connected to the package circuit, and the package circuit is connected to the circuit on the circuit board, to implement an electrical connection between the semiconductor structure and the circuit board. It may be understood that the foregoing semiconductor structure may be obtained by using the semiconductor structure manufacturing method in the foregoing embodiment.

In an implementation in which the electronic component is the central processing unit, a gate all around transistor in the semiconductor structure may be a logic device of the central processing unit. Alternatively, in an implementation in which the electronic component is a memory, a gate all around transistor in the semiconductor structure may be a switch device. A function of the gate all around transistor is not limited in embodiments of this application.

The foregoing descriptions are merely specific implementations of embodiments of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A semiconductor structure manufacturing method, comprising:
forming a stacked structure on a substrate, wherein the stacked structure comprises a plurality of sacrificial layers and a plurality of channel layers that are alternately stacked;
forming a plurality of dummy gate structures on the stacked structure, wherein the plurality of the dummy gate structures are spaced apart;
forming a first mask layer on each of the dummy gate structures, wherein the first mask layer covers a side wall that is of the dummy gate structure and that is adjacent to the stacked structure;
forming a second mask layer on the first mask layer;
removing a portion of the stacked structure by using the second mask layer as a mask, to form a plurality of first grooves, wherein the first grooves extend to the substrate;
removing a portion of the sacrificial layer on a wall of the first groove to form a void;
removing the second mask layer;
forming, by using the first mask layer as a mask, a second groove extending to the substrate; and
forming, at the second groove, an electrode structure in contact with each of the channel layers.

2. The semiconductor structure manufacturing method according to claim 1, before forming the second mask layer on the first mask layer, the method further comprises:
forming a stop layer on the first mask layer, wherein etch selectivity of the stop layer is not equal to either etch selectivity of the first mask layer or etch selectivity of the second mask layer; and
before forming, by using the first mask layer as the mask, the second groove extending to the substrate, the method further comprises: removing the stop layer.

3. The semiconductor structure manufacturing method according to claim 1 or 2, wherein removing the portion of the sacrificial layer on the wall of the first groove to form the void comprises:
removing a portion of the channel layer that is in contact with the sacrificial layer while removing the portion of the sacrificial layer on the wall of the first groove, to form a thinned region on the channel layer.

4. The semiconductor structure manufacturing method according to claim 3, wherein forming, by using the first mask layer as the mask, the second groove extending to the substrate comprises:
removing at least a portion of the thinned region on each of the channel layers while forming the second groove.

5. The semiconductor structure manufacturing method according to any one of claims 1 to 4, wherein before removing the second mask layer, the method further comprises:
forming a filler in the void.

6. The semiconductor structure manufacturing method according to claim 5, wherein forming the filler in the void comprises:
forming a first dielectric layer on the wall of the first groove, wherein a portion of the first dielectric layer is filled in the void to form the filler; and
removing the first dielectric layer on the wall of the first groove.

7. The semiconductor structure manufacturing method according to any one of claims 1 to 6, wherein forming, at the second groove, the electrode structure in contact with each of the channel layers comprises:
forming the electrode structure by epitaxial growth based on the channel layer on a wall of each second groove.

8. The semiconductor structure manufacturing method according to any one of claims 1 to 7, wherein after forming, at the second groove, the electrode structure in contact with each of the channel layers, the method further comprises:
replacing the sacrificial layers with gate layers, wherein the gate layers are connected to each other.

9. A semiconductor structure, wherein the semiconductor structure is obtained by using the semiconductor structure manufacturing method according to any one of claims 1 to 8.

10. An electronic component, comprising a package substrate and the semiconductor structure according to claim 9, wherein the semiconductor structure is disposed on the package substrate.

11. An electronic device, comprising a circuit board and the electronic component according to claim 10, wherein the electronic component is disposed on the circuit board.
